# DEMANDE DE BREVET EUROPEEN

(11) **EP 0 570 257 A1**
(43) Date de publication de la demande: **18.11.1993**
(21) Numéro de dépôt: 93401148.7
(22) Date de dépôt: 04.05.1993
(51) Int. Cl.: H01L 29/08, H01L 29/784, H01L 27/115, H01L 21/336

(54) **Dispositif semiconducteur à effet de champ avec grille secondaire, procédé de réalisation et application à un dispositif à commande matricielle**

(30) Priorité: 15.05.1992 FR 9205922
(71) Demandeur: THOMSON-CSF, 75008 Paris (FR)
(72) Inventeur: Pribat, Didier, F-92402 Courbevoie Cedex (DE); Stroh, Rudiger Joachim, F-92402 Courbevoie Cedex (DE); Legagneux, Pierre, F-92402 Courbevoie Cedex (DE); Gerard, Bruno, F-92402 Courbevoie Cedex (DE)
(74) Mandataire: Guérin, Michel

(57) **Abrégé**

Dispositif à semiconducteur à effet de champ comportant au moins une grille secondaire (GS2) située au-dessus du canal (C) à proximité du drain (D). Cette grille secondaire (GS2) ne comporte aucune connexion électrique extérieure et est portée à un potentiel flottant ou est chargée à un niveau déterminé de façon à induire dans le canal une zone d'inversion (d'accumulation). Cette grille (GS2) peut être en diélectrique chargé. Elle peut être également en semiconducteur que l'on porte à un potentiel flottant par polarisation inverse de la jonction drain canal.

L'invention concerne également un procédé de réalisation de ce dispositif.
Application :
- Réalisation de dispositifs à effet de champ à grilles secondaires (de transistors notamment) sans avoir besoin d'électrodes de connexion pour ces grilles secondaires.
- Commande de dispositifs matriciels.

## Description

L'invention concerne un dispositif semiconducteur à effet de champ et plus particulièrement un transistor à effet de champ du type MOS (Metal/ Oxyde/ Semiconducteur) fabriqué dans du silicium monocristallin ou polycristallin sur isolant. Elle concerne également un procédé de réalisation de ce dispositif et une application à un dispositif à commande matricielle.

La structure proposée permet de réduire les courants de fuite à l'état bloquant. Sans que ceci soit limitatif, l'invention peut avantageusement être appliquée aux transistors à base de silicium polycristallin, et en particulier à ceux destinés à être utilisés pour la commande des pixels d'écrans plats à cristaux liquides et à matrice active.

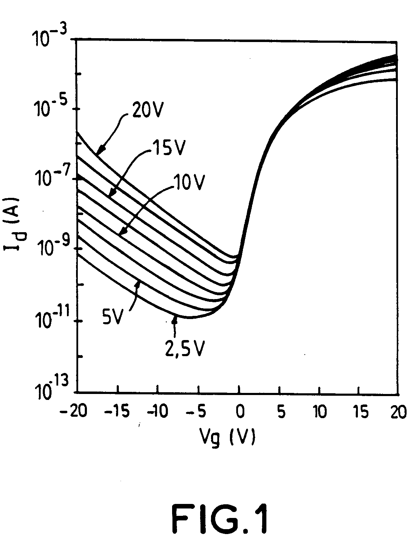

La figure 1 représente un réseau de caractéristiques de transfert typiques d'un transistor de type MOS à canal de type n fabriqué à partir de silicium polycristallin déposé sur substrat de verre ou de quartz.

Cette figure est tirée de l'article de Keiji TANAKA et Collaborateurs, publié dans les "Extended Abstracts of the 22nd (1990 International) Conference on Solid State Devices and Materials" Sendai 1990, pp. 1011-1014. Il apparaît que le courant du transistor à l'état bloquant est d'autant plus important que
- la tension de drain V_{D} est élevée,
- et que la valeur absolue de ]a tension de grille V_{G} est élevée.

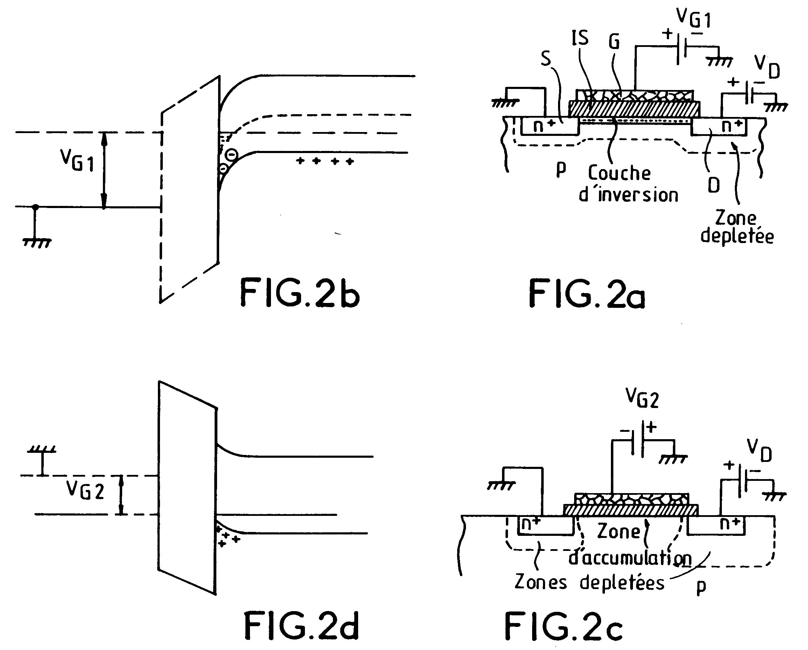

Les figures 2a à 2d illustrent une structure de transistor à effet de champ connue dans la technique et ses différents états de conduction. Un tel transistor possède, dans un substrat semiconducteur de type p, deux zones dopées de type n⁺⁺. Ces zones de type n⁺⁺ tiennent lieu de drain D et de source S et sont donc séparées par une zone de type p. Au-dessus de cette zone de type p est localisée une couche d'isolant IS sur laquelle est située une électrode métallique de grille G.

Sur les figures 2a et 2b, l'application d'une tension positive sur la grille induit la formation d'une couche d'inversion dans le canal, la référence des tensions étant la source qui est connectée à la terre ; le transistor est passant. Sur les figures 2c et 2d, on a représenté le cas où la tension de grille est négative, ce qui induit la formation d'une couche d'accumulation dans le canal. Dans ces conditions, la structure drain-source est constituée de deux jonctions tête-bêche et le transistor est bloquant.

Pour cette dernière configuration, on constate cependant que plus V_{G} est élevée en valeur absolue, plus la concentration de trous dans la zone d'accumulation est élevée c'est-à-dire, à V_{D} constant, plus le champ électrique dans la jonction drain-canal (ainsi d'ailleurs que dans la jonction canal-source) est élevé. De même, à V_{G} constant (mais toujours négatif), plus V_{D} est élevé, plus le champ électrique dans la jonction drain-canal est aussi élevé. Si l'on suppose que le mécanisme de fuite à travers la jonction dépend du champ électrique (ce que l'on va confirmer dans la suite), on comprend mieux la forme des courbes de la figure 1.

De façon générale, les régions de contacts de source et de drain (région n⁺⁺ sur les figures 2a et 2c) sont fabriquées par implantation ionique, éventuellement autoalignées par la grille. En ce qui concerne les matériaux semiconducteurs tels que silicium sur isolant, les températures de traitement thermique (oxydation, recuit d'implantation ...) sont toujours maintenues basses (≦ 950°C pour des substrats isolants réfractaires tels que saphir, quartz ou silicium oxydé et ≦ 600°C pour des substrats en verre) pour des raisons complexes de multiplication de défauts, de changement de type du silicium déposé ou tout simplement de ramollissement du substrat. Il en résulte que le recuit d'implantation est imparfait, ce qui conduit à la génération de niveaux profonds dans le gap du semiconducteur.

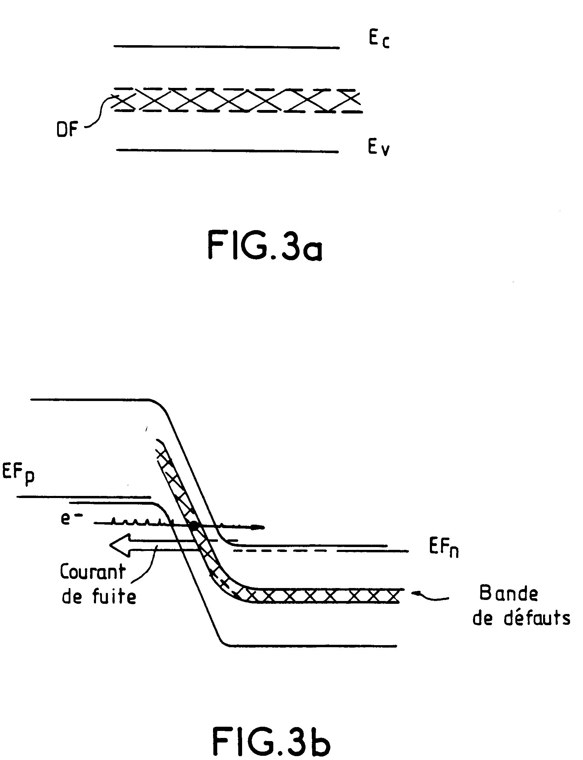

Dans ces conditions, un examen des figures 3a et 3b permet de mieux comprendre le mécanisme de fuites électriques à travers une jonction du type drain-canal polarisée en inverse. On a représenté sur la figure 3a la structure de bande du semiconducteur avec des niveaux profonds situés en milieu du gap. Pour des raisons didactiques on a représenté une bande de niveaux profonds DF, dont l'introduction sera supposée consécutive à un recuit d'implantation imparfait.

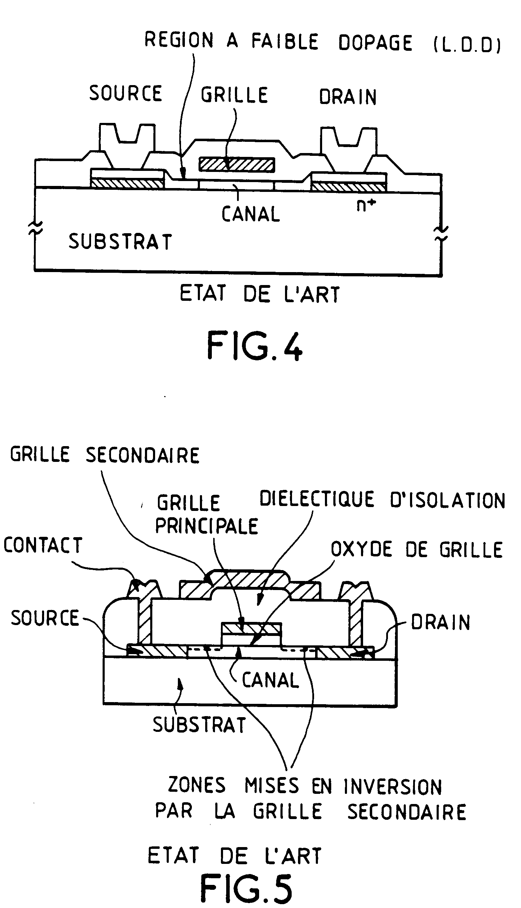

Sur la figure 3b, on a représenté une jonction de type drain-canal polarisée en inverse (situation décrite sur les figures 2c et 2d) ; on constate qualitativement que plus la polarisation inverse est élevée (donc plus le champ électrique est élevé), plus la probabilité d'effet tunnel assisté par défauts à travers la jonction est élevée. Afin de minimiser le courant de fuite, on a donc intérêt à diminuer soit le champ électrique dans la jonction, soit la densité de niveaux profonds dans cette même jonction. On peut diminuer le champ électrique en effectuant un dopage graduel côté drain, de manière à obtenir une structure dite LDD (Ligthly Doped Drain). L'efficacité de ce type de structure, représentée sur la figure 4, a été démontrée en particulier par Keiji NAKAZAWA et Collaborateurs dans un article publié dans "Society of Information Display 1990 Digest", p. 311. L'inconvénient cependant de ce type de structure réside dans la diminution du courant des transistors à l'état passant (diminution de 1 à 2 ordres de grandeur) à cause de l'effet de résistance série dû à la région faiblement dopée.

Afin de diminuer les densités de défauts dans la jonction, une seconde approche peut être utilisée, qui consiste à déporter la jonction drain-canal hors de la région ou a lieu l'implantation ionique.

Cette deuxième approche, qui vise à diminuer la densité de défauts d'implantation résiduels dans la zone de la jonction drain-canal, a été étudiée par K. TANAKA et Collaborateurs (déjà cités) ainsi que par Tiao-Yuan HUANG et Coll. (dans un article paru dans IEEE Electron Device Letters, Vol. 11, n° 11, Novembre 1990, p. 541). Afin de déporter les régions de contacts ohmiques de source et de drain, sans implantation ionique, les auteurs cltés ci-dessus utilisent une deuxième grille métallique, qui permet de mettre en inversion les régions du canal comprises entre la zone implantée et le bord de grille, de part et d'autre de la grille. La figure 5 schématise la structure du transistor utilisé par TANAKA dans le document cité précédemment. L'application d'une tension approprlée sur la grille secondaire permet de mettre en inversion les parties du canal comprises entre la grille principale et les zones de source et de drain. Cependant l'utilisation de cette structure pose quelques problèmes pratiques, à savoir :
1. Du fait de l'épaisseur relativement importante du diélectrique d'isolation, la tension à appliquer sur la grille secondaire est élevée, de l'ordre de 30 à 60 V.
2. Le transistor devient un dispositif à quatre électrodes, ce qui peut poser des problèmes de connectique.
3. Si l'on relie la grille secondaire à l'électrode de drain, ce qui vise à résoudre le problème de connectique, le transistor ne sera pas passant pour toutes les valeurs de tension de drain (à tension de grille positive comme mentionné dans le document TANAKA précédent). Il faut donc pratiquement envisager une polarisation distincte de la grille secondaire.

La présente invention permet d'éviter l'utilisation d'une quatrième électrode ainsi que l'utilisation d'une liaison drain-grille secondaire. Elle permet de plus d'obtenir un transistor passant pour n'importe quelle valeur positive de tension de grille (dans le cas d'un transistor à canal n tels que représenté en figures 2a et 2c).

L'invention concerne un dispositif semiconducteur à effet de champ comprenant une zone de source et une zone de drain en matériau semiconducteur dopées d'un premier type et séparées par un canal en matériau semiconducteur intrinsèque ou dopé d'un deuxième type, caractérisé en ce qu'il comporte au moins une grille secondaire, sans connexion extérieure chargée électriquement à un niveau flottant sensiblement déterminé, cette grille secondaire étant située dans un plan parallèle au canal et en regard de celui-ci.

Plus particulièrement, l'invention concerne un dispositif à effet de champ comprenant une zone de source et une zone de drain en matériau semiconducteur dopées d'un premier type séparées par un canal en matériau semiconducteur dopé d'un deuxième type ou bien intrinsèque, dont l'état de conduction est commandé par une grille principale, caractérisé en ce qu'il comporte au moins une grille secondaire chargée électriquement à un niveau flottant sensiblement déterminé ou bien comportant une densité contrôlée de charges fixes, cette grille étant située dans un plan parallèle au canal, en regard du canal et isolé de celui-ci, et à proximité du drain.

L'invention concerne également un procédé de réalisation d'un transistor à effet de champ, caractérisé en ce qu'il comprend la réalisation sur un substrat d'une couche de matériau semiconducteur comportant deux zones de source et de drain dopées d'un type déterminé reliée par un canal dopé d'un autre type ou bien intrinsèque et de deux grilles secondaires situées au-dessus du canal, à proximité chacune d'une zone de source ou de drain puis d'une grille principale située dans une zone dont la projection dans le plan du canal est sensiblement entre les grilles secondaires ; la jonction source-canal on la jonction drain-canal ou les deux jonctions étant ensuite fortement polarisées temporairement en inverse, de manière à venir charger les grilles secondaires flottantes, par injection de porteurs à travers le diélectrique d'isolation.

Les différents objets et caractéristiques de l'invention apparaîtront plus clairement dans la description qui va suivre faite à titre d'exemple en se reportant aux figures annexées qui représentent :
- les figures 1 à 5, des dispositifs connus dans la technique et décrits dans ce qui précède ;
- les figures 6a et 6b, un premier exemple de réalisation d'un dispositif selon l'invention ;
- la figure 7, un deuxième exemple de réalisation d'un dispositif selon l'invention ;
- les figures 8a à 8i, un procédé de réalisation du dispositif des figures 6a et 6b ;
- les figures 9 à 9g et 10a à 10g, deux variantes selon le procédé des figures 8a à 8i ;
- les figures 11a à 11g, un procédé de réalisation du dispositif de la figure 7 ;
- les figures 12a et 12b, des modes de représentation de transistors à effet de champ ;
- les figures 13a et 13b, un exemple de réalisation d'un transistor à effet de champ à grille secondaire rechargeable ;
- les figures 14a et 14b, une variante de réalisation des figures 13a et 13b ;
- les figures 15a et 15b, des applications du transistors de l'invention à la réalisation de dispositifs matriciels.

Le principe de l'invention consiste à prévoir de part et d'autre du canal du transistor à effet de champ deux zones d'inversion ou d'accumulation permanentes. Cela peut se faire à l'aide de charges appropriées injectées sur deux grilles secondaires flottantes placées de part et d'autre du canal, ou bien à l'aide de charges injectées à l'interface entre deux couches diélectriques (par exemple Si₃N₄ et SiO₂) aussi disposés de part et d'autre du canal, ou bien encore à l'aide de charges piégées dans un seul diélectrique comportant deux branches toujours disposées de part et d'autre du canal.

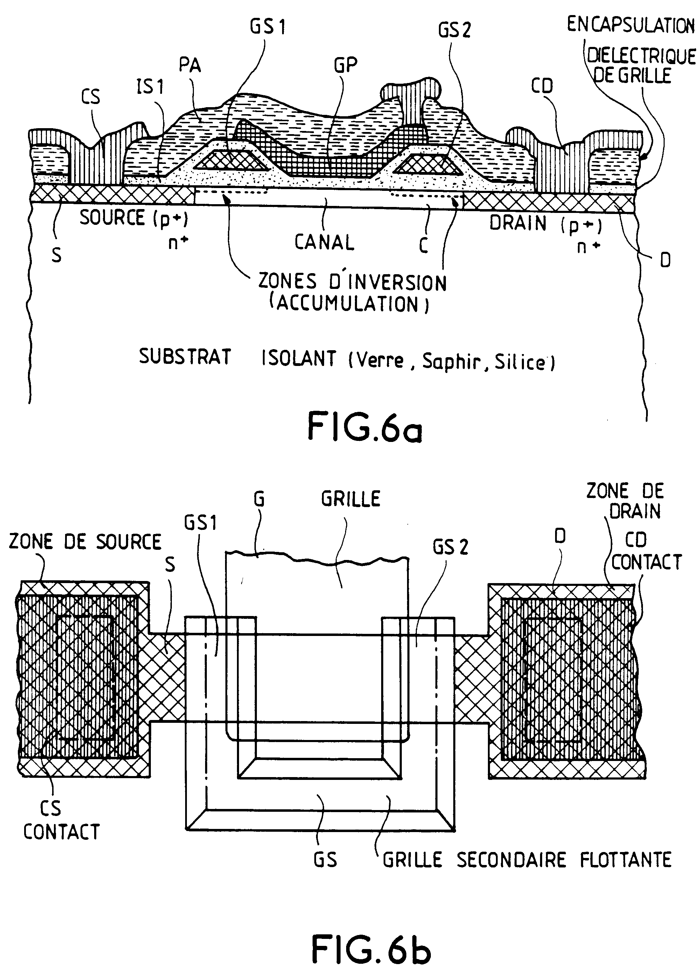

Les figures 6a et 6b représentent un exemple de réalisation d'une structure de transistor selon l'invention dans le cas où le canal est bordé de part et d'autre par deux grilles secondaires flottantes.

La figure 6a représente en coupe un transistor selon l'invention dans lequel une zone de source S et une zone de drain D en matériau semiconducteur dopé d'un type déterminé sont implantées sur un substrat. Ces zones sont reliées par un canal C en matériau semiconducteur dopé d'un autre type ou bien intrinsèque. Au-dessus du canal, séparée par une couche d'isolant IS1 se trouve la grille GP. Selon l'invention, entre la grille GP et les zones de source et drain se trouvent deux grilles secondaires GS1 et GS2 locallsées au-dessus du canal, l'une d'elles à la frontière du canal et de la zone de drain, l'autre à la frontière du canal et de la source. Ces grilles secondaires sont isolées du canal et de la grille principale GP.

La figure 6b représente en vue de dessus un exemple de réalisation du transistor de la figure 6a dans lequel les deux grilles sont faites en une seule pièce et constituent donc une seule grille secondaire GS possédant deux branches GS1 et GS2.

Les zones de source S et de drain D sont munies de contacts CS et CD. En fonctionnement, ces contacts CS et CD ainsi que la grille GP sont connectés à des sources électriques comme représenté en figures 2a et 2c par exemple, tandis que la grille secondaire n'est reliée à aucune source électrique. Elle est dite flottante ou à potentiel flottant.

On supposera les zones de contact de source et de drain de type p+ et le canal intrinsèque ou de type n. Dans ces conditions, selon l'invention, on polarise la jonction drain-canal (ou bien la jonction canal-source) en inverse, jusqu'au régime d'avalanche. Des électrons sont alors injectés à partir du plasma d'avalanche sur l'une des branches de la grille secondaire flottante ; lorsque la charge injectée est suffisante, on coupe la polarisation de drain ou de source ; les charges stockées sur la grille secondaire font apparaître une couche d'inversion dans la région du canal sous jacente (voir figure 6a).

On a ainsi déporté la zone de "dopage" n+ hors de la zone d'implantation ionique. En d'autres termes, la zone de transition entre le canal et les contacts de source et drain se trouve ainsi située hors de la zone ayant subi l'implantation ionique. De ce fait, la densité de niveaux profonds dans le gap, au niveau de la jonction, se trouve dimlnuée et par suite la probabilité de transfert par effet tunnel assisté se trouve aussi diminuée ; on a donc amélioré le courant de fuite du transistor.

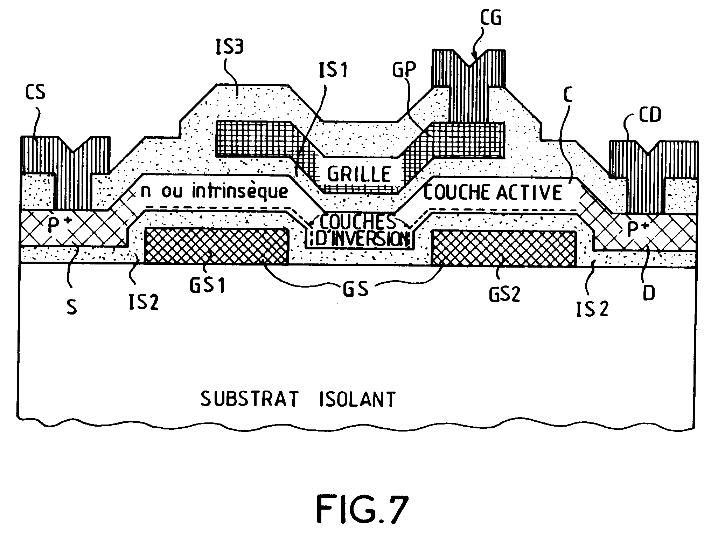

La figure 7 présente une structure de transistor en vue de coupe dans laquelle la grille secondaire flottante GS et la grille principale GP sont placées de part et d'autre du canal C. La grille secondaire GS est par exemple réalisée sur un substrat et est recouverte d'une couche d'isolant IS2. Sur la couche d'isolant IS2 se trouve une couche d'un matériau semiconducteur comportant, de part et d'autre des branches GS1 et GS2 de la grille secondaire GS, deux zones dopées d'un type déterminé et constituant une zone de source et une zone de drain. Entre ces deux zones se trouve le canal du transistor. L'ensemble est recouvert d'une couche d'isolant IS1 sur laquelle est réalisée la grille principale GP qui est elle-même recouverte par une couche d'isolant de passivation IS3. Des contacts métalliques CS, CG, CD traversent les couches d'isolant IS1 et IS3 pour fournir des connexions de source, de grille et de drain.

Le principe de fonctionnement de ce transistor est identique à celui des figures 6a et 6b. Il consiste à charger la grille flottante GS par injection à partir du plasma d'avalanche créé par la forte polarisation en inverse de la jonction drain-canal.

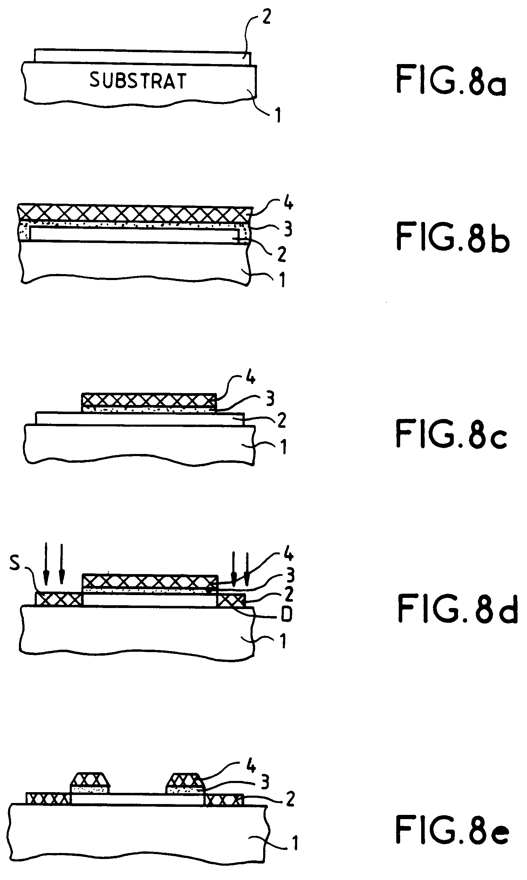

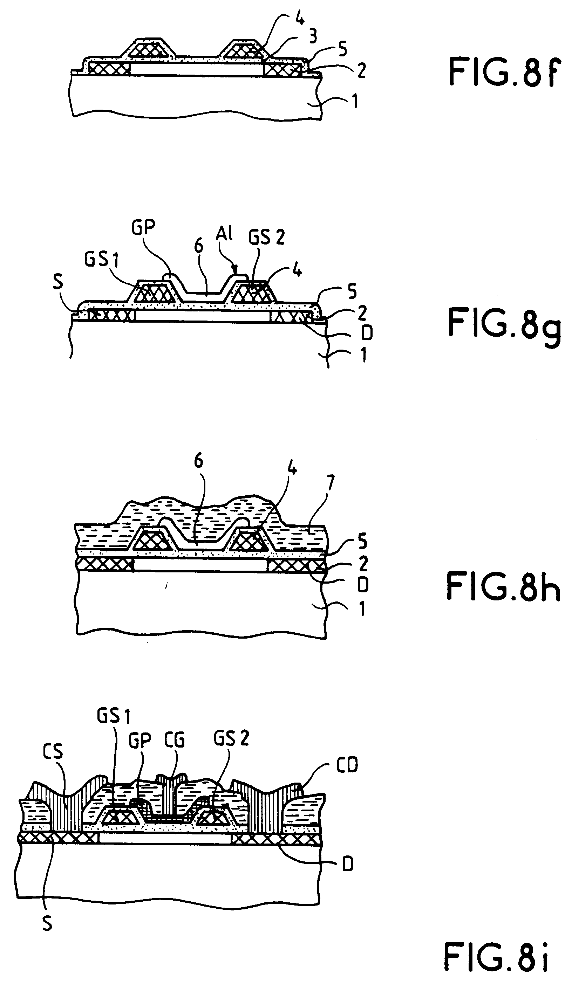

On a représenté sur les figures 8a à 8i un procédé de fabrication du dispositif des figures 6a et 6b. A titre d'exemple, ce procédé décrit utilise une technologie silicium mais il pourrait utiliser toute autre technologie à semiconducteur.
- Etape 1. On part d'une couche mince 2 de semiconducteur (silicium par exemple) sur substrat isolant 1 (silicium de base). Cette couche mince 2 peut être par exemple du matériau de type SIMOX (Separation by IMplantation of OXygen), ou bien du silicium sur saphir etc... On grave des pavés dans cette couche 2, correspondant aux zones où l'on va réaliser des transistors (figure 8a).
- Etape 2. On dépose une première couche de diélectrique 3 (tel que SiO₂ ou Si₃N₄) d'épaisseur par exemple 0,05 à 0,1 µm ; on dépose ensuite par exemple une couche de semiconducteur polycristallin 4 (polysilicium dopé n⁺⁺, dégénéré) et d'épaisseur 0,1 à 0,5 µm par exemple (figure 8b). Cette couche peut aussi être de nature métallique.
- Etape 3. On grave l'ensemble des couches 3 et 4 en s'arrêtant sur la couche 2 de semiconducteur pour définir les régions de source et de drain S et D (figure 8c).
- Etape 4. On pratique une implantation ionique, en utilisant comme masque d'alignement l'ensemble des couches 3 et 4 en poly dégénéré et en diélectrique. On réalise ainsi les régions de source et de drain S et D concernant le transistor (figure 8d). On pratique le recuit d'implantation à une température adéquate.
- Etape 5. On effectue une deuxième opération de gravure dans les couches 3 et 4, de manière à définir les grilles secondaires GS1, GS2. On notera que le positionnement du masque n'est pas critique (figure 8e).
- Etape 6. On reforme (par dépôt ou oxydation) une deuxième couche de diélectrique 5 (diélectrique de grille) d'épaisseur 0,05 à 0,1 µm (figure 8f).
- Etape 7. On dépose une couche de métal 6 (aluminium ou poly-Si dégénéré typiquement) pour la grille principale GP de transistor (figure 8g).
- Etape 8. On encapsule l'ensemble à l'aide d'un matériau isolant 7 (du type SiO₂, Si₃N₄ ou BoroPhosphoSilicate Glass BPSG) (figure 8h).
- Etape 9. On ouvre les zones de contact dans les couches 7, 5, on dépose un métal conducteur (l'aluminium) et on grave les contacts CS, CD et CG (figure 8i).
- Etape 10. On polarise ensuite en inverse la jonction drain-canal par exemple, de manière à charger les grilles flottantes GS1 et GS2.

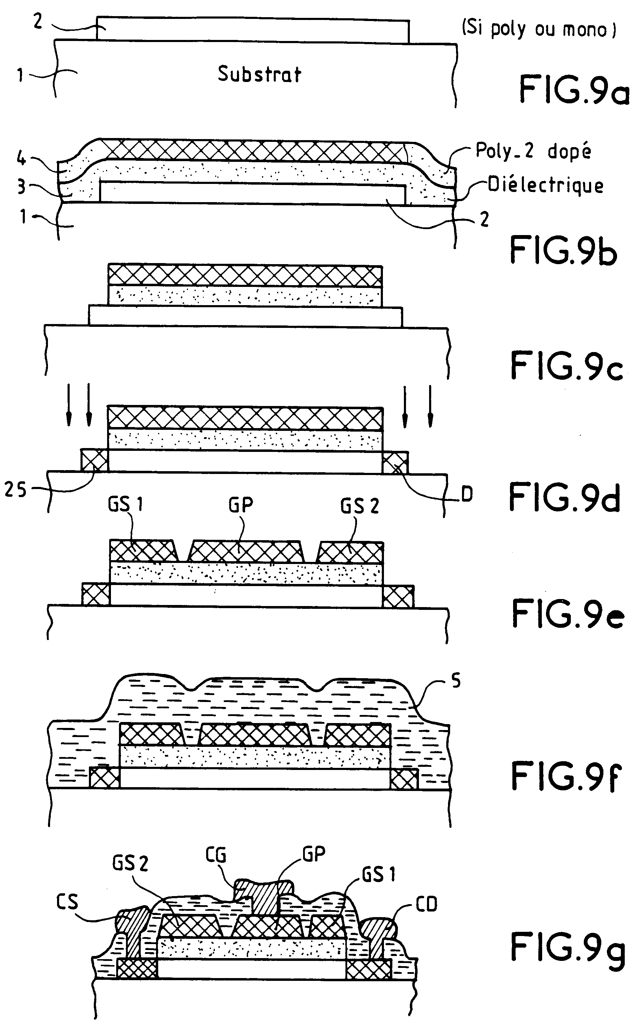

Les figures 9a à 9g représentent une variante du procédé de réalisation du dispositif des figures 6a et 6b. Ce procédé comporte les étapes suivantes :
- Etape 1. On réalise une couche mince 2 de semiconducteur (silicium par exemple) sur un substrat isolant 1. On grave des pavés dans cette couche 2, correspondant aux zones où l'on va réaliser des transistors (figure 9a).
- Etape 2. On dépose une première couche de diélectrique 3 (tel que SiO₂ ou Si₃N₄) d'épaisseur par exemple 0,05 à 0,1 µm ; on dépose ensuite une couche de semiconducteur 4 (par exemple silicium polycristallin) dopé n⁺⁺ (dégénéré) et d'épaisseur 0,1 à 0,5 µm par exemple (figure 9b).
- Etape 3. On grave l'ensemble des couches 3 et 4 en s'arrêtant sur la couche 2 de semiconducteur pour définir les régions de source et de drain S et D (figure 9c).
- Etape 4. On réalise une implantation ionique 25 (figure 9d).
- Etape 5. On effectue une deuxième opération de gravure dans la couche 4 (figure 9e) pour définir les différentes grilles principales (GP) et secondaires (GS1 et GS2). On notera que le positionnement du masque n'est pas critique. L'intervalle entre les différentes grilles sera aussi faible que possible (typiquement 1 µm par exemple) de façon à limiter la résistance série.
- Etape 6. On encapsule l'ensemble à l'aide d'un matériau isolant 5 (du type SiO₂, Si₃N₄ ou BPSG) (figure 9f).
- Etape 7. On ouvre les zones de contact dans la couche encapsulante 5 et on dépose un métal conducteur (aluminium par exemple, pour réaliser les contacts de source (CS), de drain (CD) et de grille (CG) (figure 9g).
- Etape 8. On polarise ensuite en inverse la jonction drain-canal et source-canal pour charger les grilles secondaires.

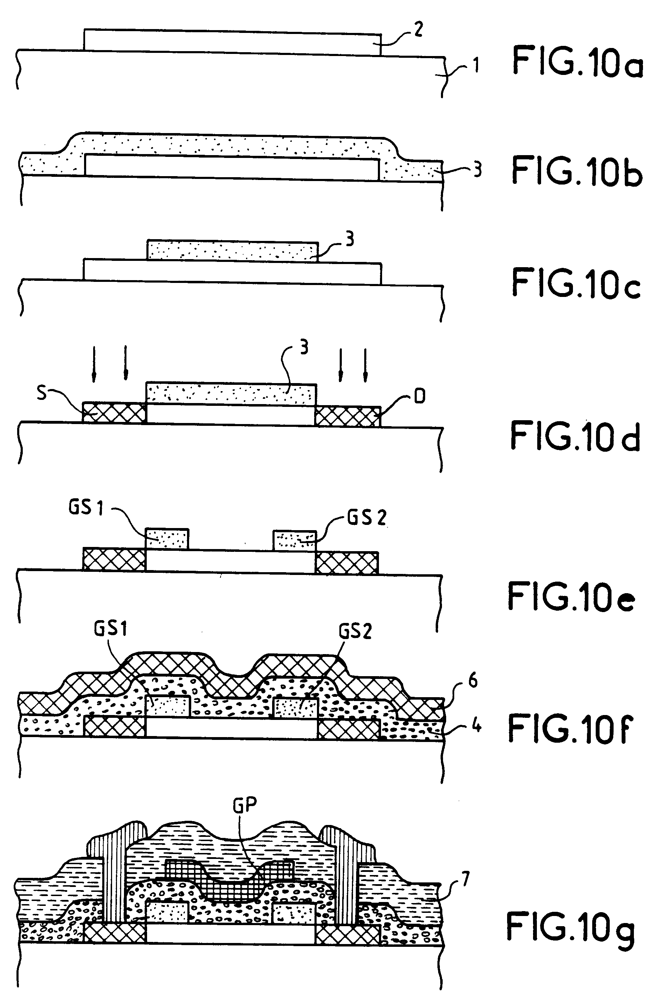

En se reportant aux figures 10a à 10g, on va décrire une autre variante du procédé de réalisation du dispositif des figures 6a et 6b. Cette variante de procédé comporte les étapes suivantes :
- Etape 1. On part d'une couche mince 2 de semiconducteur (silicium par exemple) sur substrat isolant 1. On grave des pavés dans cette couche 2, correspondant aux zones où l'on va réaliser des transistors (figure 10a).
- Etape 2. On dépose une première couche 3 de diélectrique chargé, d'épaisseur par exemple 0,05 à 0,1 µm (figure 10b). Cette couche 3 est par exemple du Si₃N₄ non stoechiometrique, réalisée en jouant sur les quantités relatives de NH₃ et SIH₄ au cours d'un dépôt de type PECVD (Plasma Enhanced Chemical Vapor Deposition). On obtient en général un matériau comprenant un excès de charges positives, susceptible de mettre un canal p en inversion ou bien un canal n en accumulation.
- Etape 3. On grave cette couche 3 (figure 10c).
- Etape 4. On effectue l'implantation ionique des zones sources S et drain D des transistors (figure 10d).
- Etape 5. On effectue une nouvelle gravure de la couche de diélectrique 3 de façon à définir les grilles secondaires GS1 et GS2 (figure 10e) sans que cela nécessite une précision de la position de la gravure.
- Etape 6. On forme une deuxième couche de diélectrique 4 (de la sillce stoechiometrique par exemple) (diélectrique de grille principale) d'épaisseur 0,05 à 0,1 µm par exemple. Puis on dépose une couche 6 de métal ou de semiconducteur polycristallin fortement dopé (figure 10f) de grille.
- Etape 7. On grave la couche 6 pour réaliser la grille principale (GP) du transistor. On dépose une couche de diélectrique encapsulante 7, dans laquelle on grave des ouvertures pour le dépôt des métallisations de contacts de source et de drain CS et CD (figure 10g).

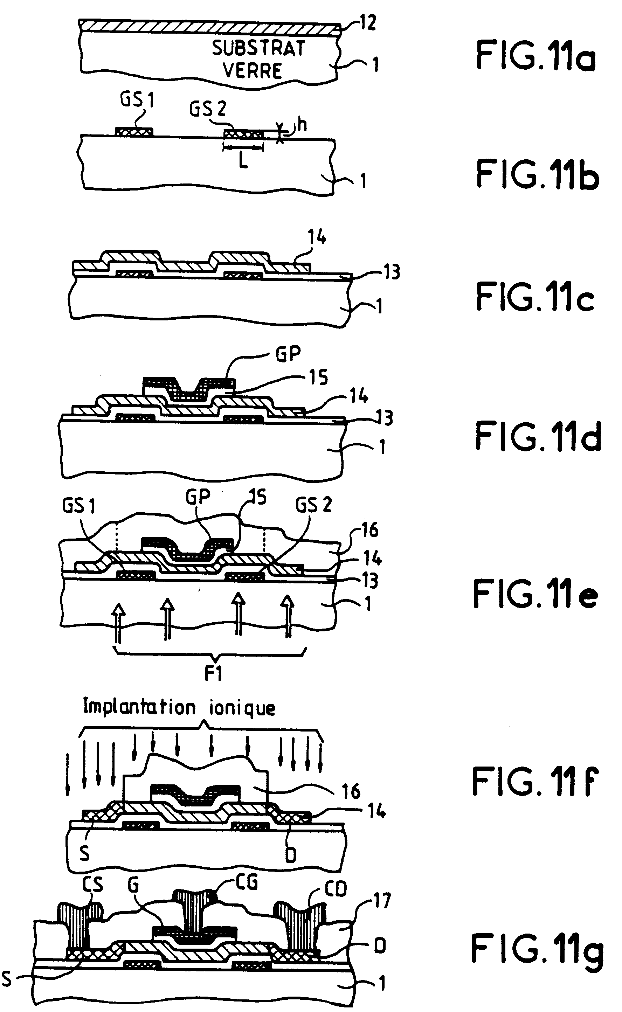

En se reportant aux figures 11a à 11h, on va maintenant décrire un procédé de fabrication d'un dispositif tel que celui de la figure 7. Ce dispositif est réalisé ci-après en technologie silicium mais il pourrait être réalisé dans toute autre technologie à semiconducteur.
- Etape 1. On dépose sur un substrat 1 isolant ou couvert par une couche isolante, une couche 12 de silicium dopé n⁺⁺ (figure 11). Ce substrat peut être transparent à la longueur d'onde d'insolation qui sera utilisée à l'étape 5 qui va suivre (verre en particulier).
- Etape 2. On grave des motifs correspondant aux grilles secondaires GS1 et GS2. L'épaisseur h de chaque grille est par exemple de 0,3 à 0,6 µm et sa longueur L d'environ 10 µm (figure 11b).
- Etape 3. On dépose une couche de matérlau diélectrique 13 ainsi qu'une couche de silicium actif 14 ; on grave les pavés de silicium actif dans lesquels seront fabriqués les transistors (figure 11c).
- Etape 4. On dépose une couche de diélectrique 15 de grille ainsi que la métallisation de grille GP (ou bien un deuxième polysilicium dégénéré de grille). On grave l'ensemble, de façon à ce que la grille principale GP soit sensiblement positionnée entre les deux grilles secondaires GS1 et GS2, mais sans précision particulière. On notera ici encore que le positionnement de la grille principale GP par rapport aux grilles secondaires n'est absolument pas critique (figure 11d).
- Etape 5. On dépose une couche de résine photosensible 16 que l'on insole par la face arrière à l'aide d'un faisceau F1, à travers le substrat, ce qui nécessite que ce substrat soit transparent à la longueur d'onde d'insolation. Dans ces conditions, l'ensemble grilles secondaires et grille principale étant opaque (à cause de la présence de polysicilium très absorbant), le masque de résine se trouve autoaligné avec les extrémités latérales des éléments de grilles secondaires GS1 et GS2 (figure 11e). Si le substrat n'est pas transparent, l'insolation de la couche photosensible se fait par le dessus de la structure à l'aide d'un niveau de masquage supplémentaire (masque mécanique par exemple).
- Etape 6. En utilisant le masque autoaligné de résine, on pratique l'implantation (de ce fait aussi autoalignée) des zones de source S et de drain D ; on élimine ensuite la résine (16) et on effectue le recuit d'activation des dopants précédemment implantés (figure 11f).
- Etape 7. On encapsule l'ensemble à l'aide d'un matériau isolant 17 dans lequel sont gravées des ouvertures pour les contacts. On dépose l'aluminium et on le grave de façon à réaliser les plots de contacts métalliques CS, CG et CD (figure 11g).

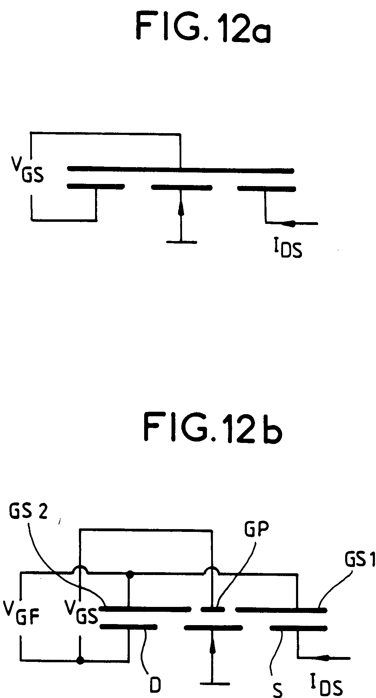

La figure 12a représente de façon symbolique un transistor à effet de champ comme cela se fait couramment. Dérivé de cette représentation symbolique, nous avons représenté en figure 12b, un transistor à effet de champ selon l'invention possédant des grilles secondaires GS1 et GS2. Cette représentation symbolique sera utilisée dans la description qui va suivre. On va décrire dans ce qui suit un dispositif de recharge des grilles flottantes.

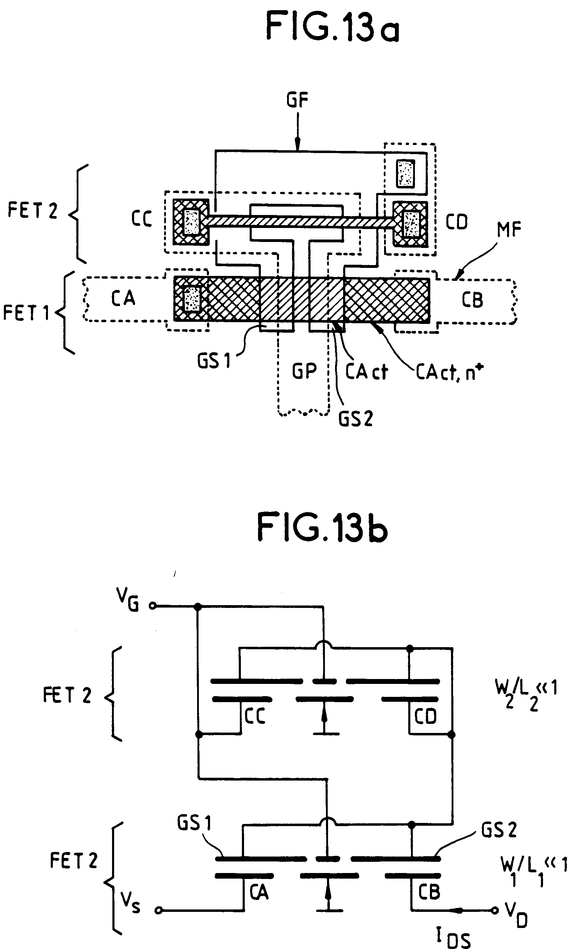

Les figures 13a et 13b représentent un transistor à effet de champ FET1 tel que décrit précédemment auquel est combiné un élément FET2 qui peut être également un transistor à effet de champ de même type que FET1.

La structure du transistor FET2 est telle qu'elle a été décrite précédemment.

Le transistor FET2 possède des grilles secondaires qui sont des prolongements des grilles secondaires GS1 et GS2 du transistor FET1. La grille principale du transistor FET2 est également un prolongement de la grille principale GP du transistor FET1. Les contacts de source et de drain du transistor FET2 sont désignés respectivement CC et CD. Le contact de drain CD est couplé aux grilles secondaires GS1 et GS2.

Lorsque le potentiel V_{GP} de grille principale GP est à une valeur très positive, le transistor FET2 est passant. Les grilles secondaires GS1, GS2 sont chargées sensiblement au potentiel de la source CC.

Lorsque le potentiel V_{GP} est rendu nul le transistor FET2 est bloqué. Cependant, dans le transistor FET2, le rapport de la section W₂ du canal à sa longueur L₂ est nettement inférieur à 1 tandis que, dans le transistor FET1, le rapport de la section W₁ du canal à sa longueur L₁ est nettement supérieur à 1. Lorsque le transistor FET2 est bloqué le courant de fuite par FET2 est, de façon plus certaine, négligeable (parce que W₂/L₂<<1) et les grilles secondaires ne peuvent se décharger.

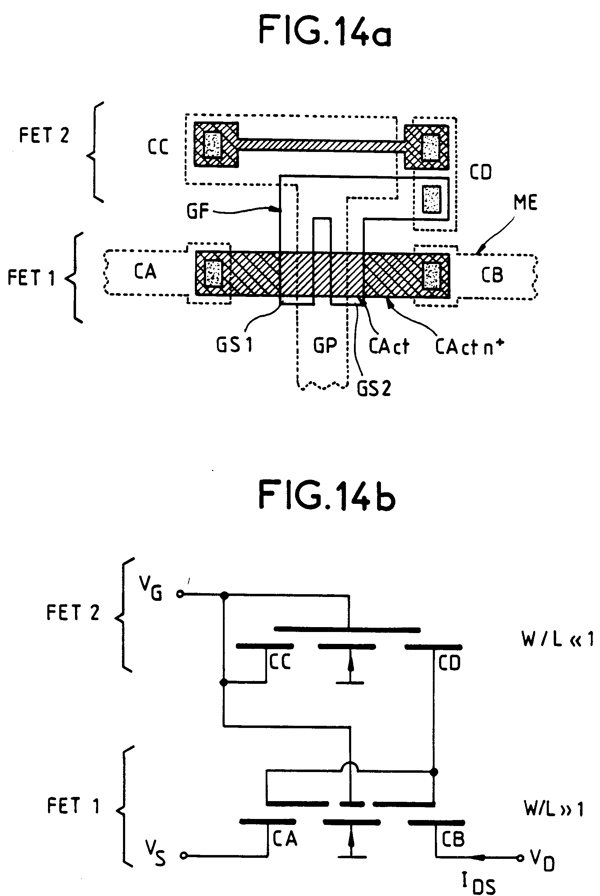

Les figures 14a et 14b représentent une variante de réalisation du dispositif des figures 13a et 13b dans lequel le transistor FET2 des figures 13 et 13b est remplacé par un transistor à effet de champ de type connu. Comme on peut le voir sur la figure 14a, le transistor FET2 est nettement séparé de la structure à effet de champ FET1. Cependant, dans ce dispositif, l'implantation ionique pour la réalisation des drains et des sources des transistors est autoalignée avec les grilles secondaires GS1 et GS2 dans le transistor FET1 mais ne peut être autoallgnée avec la grille principale GP du transistor FET2 (la grille principale GP étant réalisée après l'implantation ionique). Ce problème n'existe pas dans le dispositif des figures 13a et 13b.

Le fonctionnement du dispositif des figures 14a et 14b est similaire à celui du dispositif des figures 13a et 13b.

Dans les dispositifs des figures 13a, 13b et 14a, 14b la source (CC) et la grille du transistor FET2 sont connectées à la grille principale du FET1 mais selon une variante non représentée elles pourraient être connectées au drain (CB) du FET1. Tout autre arrangement pourrait également être envisagé.

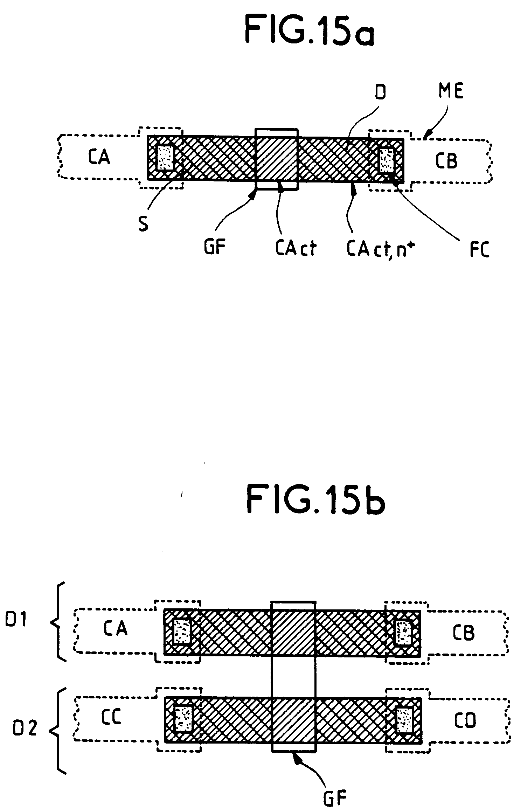

La figure 15a représente une variante de réalisation du dispositif de l'invention dans lequel on ne prévoit pas de grille principale.

Comme cela est représenté sur la figure 15a ce dispositif comporte une source S, un drain D reliés par un canal. Au-dessus du canal se trouve une grille flottante GF. Pour rendre le dispositif passant, la grille GF est chargée comme décrit précédemment par polarisation en inverse des jonctions drain-canal et/ou source-canal. Une zone ou d'accumulation est donc induite sous la grille GF rendant le dispositif passant. On a donc réalisé un interrupteur permanent.

Ce dispositif peut trouver une application notamment dans la commande d'un dispositif matriciel pour lequel on a des conducteurs de commande (conducteurs de lignes et de colonnes). Le dispositif de l'invention est alors disposé en série sur un conducteur de ligne ou de colonne et permet d'établir sur commande la continuité de ce conducteur.

Par exemple dans les dispositifs à commande matricielle tels que les écrans à cristaux liquides, on prévoit de dupliquer les conducteurs de ligne et de colonne de façon à disposer de conducteurs de secours. Pour mettre en service un conducteur, on établira donc sa continuité en chargeant la grille GF du dispositif tel que celui de la figure 15a placé en série sur le conducteur.

La figure 15b représente une variante du dispositif de la figure 15a dans lequel on a un dispositif à commander D1 tel que celui de la figure 15a.

Au dispositif D1 est associé un dispositif de charge D2. Le dispositif D2 possède également une grille flottante qui est connectée à celle du dispositif D1. Selon un exemple de réalisation préféré de l'invention, ces deux grilles flottantes forment une seule pièce.

Pour charger la grille flottante du dispositif D1 on appliquera donc des polarisations inverses au dispositif D2. De cette façon, en chargeant la grille flottante GF, on ne risquera pas de perturber le fonctionnement des circuits connectés au dispositif D1. Par exemple, dans le cas d'une application à un dispositif à commande matricielle où le dispositif D1 est placé en série sur un conducteur de colonne, les tensions inverses appliquées pour charger la grille flottante ne seront pas transmises aux circuits de commande de colonne de ce conducteur de colonne et ne perturberont pas le fonctionnement de ces circuits.

Il est bien évident que la description qui précède n'a été faite qu'à titre d'exemple. D'autres variantes peuvent être envisagées sans sortir du cadre de l'invention. Les exemples numériques ou les exemples de matériaux utilisés n'ont été fournis que pour illustrer la description. Les formes des divers éléments des dispositifs représentés peuvent être différentes. Egalement, dans les procédés de réalisation certaines étapes peuvent être combinées sans constituer des procédés différents.

## Revendications

1. Dispositif semiconducteur à effet de champ comprenant une zone de source (S) et une zone de drain (D) en matériau semiconducteur dopées d'un premier type et séparées par un canal en matériau semiconducteur intrinsèque ou dopé d'un deuxième type, caractérisé en ce qu'il comporte au moins une grille secondaire (GS1, GS2, GF), sans connexion extérieure, chargée électriquement à un niveau flottant sensiblement déterminé, cette grille secondaire étant située dans un plan parallèle au canal et en face de celui-ci.

2. Dispositif selon la revendication 1, comprenant une zone de source (S) et une zone de drain (D) en matériau semiconducteur dopées d'un premier type séparées par un canal en matériau semiconducteur dopé d'un deuxième type ou bien intrinsèque, dont l'état de conduction est commandé par une grille principale (GP), caractérisé en ce qu'il comporte au moins une grille secondaire (GS1, GS2) chargée électriquement à un niveau flottant sensiblement déterminé ou bien comportant une densité contrôlée de charges fixes, cette grille étant située dans un plan parallèle au canal, en regard du canal et à proximité du drain (D).

3. Dispositif selon la revendication 2, caractérisé en ce qu'il comporte deux grilles secondaires (GS1, GS2), l'une des grilles secondaires (GS1) étant à proximité de la source (S) et l'autre grille secondaire (GS2), à proximité du drain (D).

4. Dispositif selon l'une des revendications 1 ou 2, caractérisé en ce que la grille secondaire (GS1, GS2) est isolée.

5. Dispositif selon l'une des revendications 1 ou 2, caractérisé en ce que la grille secondaire (GS1, GS2) est en diélectrique.

6. Dispositif selon la revendication 3, caractérisé en ce que les deux grilles secondaires (GS1, GS2) sont en une seule pièce (GS).

7. Dispositif selon l'une des revendications 1 ou 2, caractérisé en ce que la zone de source (S), la zone de drain (D) et le canal sont sensiblement dans un même plan, la grille secondaire (GS1, GS2) est dans un plan parallèle à ce plan.

8. Dispositif selon l'une des revendications 1 ou 2, caractérisé en ce que la grille secondaire (GS1, GS2) est du même côté que la grille principale (GP) par rapport au canal (C).

9. Dispositif selon l'une des revendications 1 ou 2, caractérisé en ce que la grille secondaire (GS1, GS2) est d'un côté opposé à celui de la grille principale (GP) par rapport au canal.

10. Dispositif selon l'une des revendications 1 ou 2, caractérisé en ce que ledit dispositif est réalisé sur un substrat en matériau isolant transparent.

11. Dispositif selon la revendication 2, caractérisé en ce que les grilles secondaires (GS1, GS2) sont couplées au drain d'un transistor de charge (FET2) qui possède une grille de commande laquelle est couplée à la grille principale (GP) de telle façon que la commande de la grille principale (GP) détermine la conduction du transistor de charge et de ce fait la charge des grilles secondaires.

12. Dispositif selon la revendication 2, caractérisé en ce que les grilles secondaires (GS1, GS2) sont couplées au drain d'un transistor de charge (FET2) qui possède une grille de commande laquelle est couplée au drain (CB) de telle façon que la commande du drain (CB) détermine la conduction du transistor de charge (FET2) et de ce fait la charge des grilles secondaires.

13. Dispositif selon la revendication 11, caractérisé en ce que le transistor de charge (FET2) possède également deux grilles secondaires (GS1, GS2) chargées électriquement à un niveau flottant sensiblement déterminé et situées dans un plan parallèle au canal, en regard du canal, l'une des grilles secondaires (GS1) étant à proximité de la source (CC) et l'autre grille secondaire étant à proximité du drain (CD).

14. Dispositif selon la revendication 13, caractérisé en ce que les différentes grilles secondaires sont interconnectées entre elles.

15. Dispositif selon la revendication 1, caractérisé en ce qu'il comporte un deuxième dispositif semiconducteur à effet de champ (D2) possédant également une zone de source et une zone de drain séparées par un canal, caractérisé en ce que les deux dispositifs semiconducteurs à effet de champ (D1, D2) possèdent en commun une grille flottante (GF) pouvant être chargée électriquement à un niveau flottant.

16. Dispositif selon la revendication 12, caractérisé en ce qu'il comporte des moyens connectés à la source et au drain de l'un des dispositifs (D2) pour polariser en -inverse les jonctions drain-canal et source-canal de ce dispositif (D2) de façon à charger à un niveau déterminé la grille flottante (GF).

17. Procédé de réalisation d'un transistor à effet de champ, caractérisé en ce qu'il comprend la réalisation sur un substrat (1) d'une couche de matériau semiconducteur (2) comportant deux zones de source et de drain (S, D) dopées d'un type déterminé reliée par un canal (C) dopé d'un autre type et de deux grilles secondaires (GS1, GS2) situées au-dessus du canal (C), à proximité chacune d'une zone de source ou de drain (S, D) puis d'une grille principale (GP) située au-dessus des grilles secondaires ; la jonction source-canal ou la jonction drain-canal principale ou les deux jonctions étant ensuite fortement polarisées en inverse, jusqu'au régime d'avalanche.

18. Procédé de réalisation selon la revendication 14, caractérisé en ce qu'il comporte les étapes suivantes :
- réalisation sur un substrat (1) d'une couche (2) de semiconducteur, puis d'une couche de diélectrique (3), puis d'une couche de semiconducteur dopé (4) d'un premier type (n⁺⁺ par exemple) ;
- gravure des couches de diélectrique (3) et de semiconducteur fortement dopé (4) pour déterminer les zones de source et de drain ;
- implantation des zones de sources et de drain (S et D) dans la couche de semiconducteur (2) ;
- gravure dans les couches de diélectrique (3) et de semiconducteur fortement dopé (4) d'électrodes secondaires (GS1, GS2) ;
- dépôt d'une couche d'isolant (5) sur I'ensemble ;
- réalisation d'une grille principale (GP) sur la couche d'isolant (5) entre les grilles secondaires (GS1, GS2) et en partie au-dessus de celles-ci ;
- dépôt d'une autre couche d'isolant (7) sur l'ensemble obtenu et réalisation de contacts de connexions (CS, CD, CG), à travers cette couche d'isolant (7) aux zones de source et de drain (S, D) et à la grille principale (GP) ;
- polarisation en inverse de la jonction drain-canal, ou de la jonction source-canal, ou des deux jonctions.

19. Procédé de réalisation d'un transistor à effet de champ, caractérisé en ce qu'il comprend les étapes suivantes :
- réalisation sur un substrat éventuellement transparent (1) d'une couche de semiconducteur (12) fortement dopé d'un premier type et gravure dans cette couche de grilles secondaires (GS1, GS2) ;
- dépôt d'une couche d'un matériau diélectrique (13) et d'une couche de semiconducteur cristallin (14) et gravure de cette dernière couche pour déterminer les dimensions du transistor ;
- dépôt d'une autre couche de matériau diélectrique (15) et d'une couche de matériau de grille (GP) et gravure dans ces deux couches d'une grille principale (GP) située entre les grilles secondaires (GS1, GS2) et recouvrant en partie celles-ci ;
- dépôt sur l'ensemble d'une résine photosensible (16) et insolation de cette résine photosensible de façon à éliminer sensiblement la résine photosensible non située au au-dessus des grilles secondaires (GS1, GS2) et de la grille principale (GP) ;
- implantation ionique de la couche de semiconducteur (14) non protégé par la résine photosensible (16) de façon à doper d'un deuxième type les zones de source et de drain ( S, D) ;
- réalisation d'une couche d'isolation (17) sur l'ensemble obtenu et réalisation à travers cette couche d'isolation de contacts de source (CS), de drain (CD) et de grille principale (CG) ;
- polarisation en inverse de la jonction drain-canal, ou de la jonction source-canal, ou des deux jonctions.

20. Procédé selon la revendication 16, caractérisé en ce que le substrat est transparent et que l'insolation de la résine photosensible se fait à travers le substrat.

21. Application du dispositif selon l'une des revendications 1 ou 15, à un dispositif à commande matricielle, comportant des conducteurs de commande, caractérisé en ce qu'il comporte au moins un dispositif semiconducteur à effet de champ (D1) disposé en série avec un conducteur de commande.
